# EUROPEAN PATENT APPLICATION

(11) **EP 3 809 193 A1**
(43) Date of publication of application: **21.04.2021**
(21) Application number: 19203961.8
(22) Date of filing: 17.10.2019
(51) Int. Cl.: G02F 1/13

(54) **PANEL DAMAGE DETECTION ARRANGEMENT**

(71) Applicant: ALCAN Systems GmbH, 64293 Darmstadt (DE)
(72) Inventor: Ayluctarhan, Muhammed, 64285 Darmstadt (DE)
(74) Representative: Habermann Intellectual Property Partnerschaft von Patentanwälten mbB

(57) **Abstract**

Panel damage detection arrangement (1) comprising at least two non-conducting panels (2, 3). A first test conductor (4) having a first test resistance (20) is at least sectionwise attached to a test surface (7) of a first panel (2) so that a mechanical damage to the first panel (2) is determinable from an increase in the first test resistance (20). A second test conductor (5) having a second test resistance (21) is at least sectionwise attached to a test surface (9) of a second panel (3) so that a mechanical damage to the second panel (3) is determinable from an increase in the second test resistance (21). The two test conductors (4, 5) each extend from a source end (11, 14) to a measurement end (16, 17). The measurement ends (16, 17) of the two test conductors (4, 5) are electrically connected so that when a test voltage (13, 32, 34, 36) with a high test potential (11) is applied to the source end (11) of the first test conductor (4) and with a low test potential (15) to the source end (14) of the second test conductor (5) a common measurement potential (18, 33, 35, 37)created at the two measurement ends (16, 17) of the two test conductors (4, 5) shifts to a higher value if the second panel (3) is mechanically damaged and shifts to a lower value if the first panel (2) is mechanically damaged.

## Description

### Technical field

The invention relates to a panel damage detection arrangement.

### Background of the invention

It is possible that for devices comprising at least two panels a status of the panels has to be monitored during manufacturing, during operation, or both.

In liquid crystal displays a liquid crystal material is arranged in between two panels, whereby usually at least one of the two panels is made of glass or of another suitable transparent material. The liquid crystal displays operate by using light modulating properties of the liquid crystal material. The condition of the panels of the liquid crystal displays can be monitored simultaneously with the optical properties of the liquid crystal material by optical measurements. Hence, in such devices the monitoring of the status of the panels with respect to the resulting performance of the liquid crystal display is typically performed optically.

There are also known radio frequency devices as phase shift elements or antenna elements comprising a liquid crystal material arranged between two panels. In such radio frequency devices radio frequency properties of the radio frequency devices can be modulated by tuning dielectric material properties of the liquid crystal material. Inspection of such devices by measuring the radio frequency properties can be technologically complex and time-consuming. Therefore, the monitoring of the status of the panels by measuring the radio frequency properties of the radio frequency devices is unfavourable.

There are also known phased array antennas comprising a multitude of individual antenna elements typically arranged next to each other on an antenna plane. For each antenna element at least one phase shift element can be connected between the respective antenna element and a common electromagnetic wave transmitting and receiving source. By using a predetermined phase shift between the respective antenna elements and the common transmitting and receiving source a superposition of emitted or received signals can be maximized for a given direction, resulting in a preset spatial antenna characteristic of the phased array antenna. Each of the antenna elements and possibly each of the phase shift elements of the phased array antenna can be manufactured using two dedicated panels with the liquid crystal material arranged in between the two panels. Therefore, the phased array antenna can contain a large number of panels. Hence, monitoring the status of the large number of panels of the phased array antenna by measuring the radio frequency properties of the respective radio frequency devices can be impracticable.

Accordingly, there is a need to provide for a panel damage detection arrangement improving upon the aforementioned issues.

### Summary of the invention

The present invention relates to a panel damage detection arrangement comprising at least two non-conducting panels, wherein a first test conductor having a first test resistance is at least sectionwise attached to a test surface of a first panel so that a mechanical damage to the first panel is determinable from an increase in the first test resistance, wherein a second test conductor having a second test resistance is at least sectionwise attached to a test surface of a second panel so that a mechanical damage to the second panel is determinable from an increase in the second test resistance, wherein the two test conductors each extend from a source end to a measurement end, wherein the measurement ends of the two test conductors are electrically connected and wherein the first panel and the second panel with the respective test conductors form a measurement cell, so that when a test voltage with a high test potential is applied to the source end of the first test conductor and with a low test potential to the source end of the second test conductor a common measurement potential created at the two measurement ends of the two test conductors shifts to a higher value if the second panel is mechanically damaged and shifts to a lower value if the first panel is mechanically damaged. Thus, the status of the two panels can be monitored in a technologically simplified way by measuring the measurement potential present at the two measurements ends of the panel damage detection arrangement. The status of the two panels can be verified by solely monitoring the measurement potential.

The two non-conductive panels can be for instance manufactured from ceramic materials as aluminum oxide or magnesium oxide or from a silica-based glass. The two test conductors can be manufactured as thin metallic wires. In case of the test conductors manufactured as wires the at least sectionwise attached section of the wires can be bonded or glued to the test surface of the respective panel. Alternatively, the test conductors attached to the respective test surface can be formed as an electrode line deposited on the test surface by known thin film deposition methods. The material of the test electrodes can be chosen from metals as for instance copper, nickel or gold. Alternatively, the material of the electrode lines can be chosen to be a transparent conductive electrode as for instance aluminum doped zink oxide, fluorine doped tin oxide or indium tin oxide.

In case that one of the panels is mechanically damaged a cross section of the section of the test conductor attached to the test surface of the respective panel can be altered and thereby reduced in the mechanically damaged area, so that the test resistance of the respective test conductor is increased. Especially in case of the formation of a crack in one of the panels it is possible that the test conductor is ruptured so that the test resistance of the respective test conductor increases to infinity.

The test voltage applied to the respective source ends of the two panels can be a direct current voltage or an alternating current voltage. The low test potential is preferably set to ground potential. Preferably, the first test resistance and the second test resistance of the mechanically undamaged panel damage detection arrangement are of equal value. In this case the panel damage detection arrangement acts as a voltage divider and the measurement potential corresponds to half of the high test potential. With the high test potential applied to the source end of the first test conductor the measurement potential shifts to higher values in case of an increase of the second test resistance due to a mechanical damage to the second panel. In case of a ruptured second test conductor the measurement potential corresponds to the high test potential. In case of an increase of the first test resistance due to a mechanical damage to the first panel the measurement potential shifts to lower values. In case of a ruptured first test conductor the measurement potential corresponds to the low test potential.

The two panels may be arranged arbitrarily within an electronic device comprising two or more such panels. Preferably, the two panels are arranged so that the respective test surfaces are facing each other. Alternatively, the two panels can be arranged so that surfaces of the respective panel averted to the test surface are facing each other.

An electronic device that comprises two panels with a panel damage detection arrangement may comprise at least one radio frequency device as for instance a radio frequency phase shift element or a radio frequency antenna element.

To increase the chance of detecting a mechanical damage to the first or the second panel or both panels according to an advantageous aspect of the invention, the section of the first test conductor or the second test conductor or both that are attached to the respective panel runs at least sectionwise from a first end section of the respective panel to a second end section of the respective panel arranged opposite to the first end section.

To further increase the chance of detecting a mechanical damage to the first and/or the second panel according to an advantageous embodiment of the invention, the section of the first test conductor and/or the second test conductor attached to the respective panel runs at least sectionwise along an edge section of the respective panel. The section of the test conductors attached to the respective panel can for instance have a u-shaped course along the edge section.

According to another advantageous aspect of the invention, the section of the first test conductor and/or the second test conductor attached to the respective panel runs at least sectionwise along a meandering course or along a spiralling course along the respective panel.

To allow technologically simple manufacturing of the panel arrangement, according to an advantageous aspect of the invention the first test conductor and/or the second test conductor is at least sectionwise formed as an electrode line on the test surface of the respective panel.

According to an advantageous embodiment of the invention, the panel damage detection arrangement comprises source contact elements each electrically connected to one of the source ends of the test conductors and wherein the panel damage detection arrangement comprises measurement contact elements each electrically connected to one of the measurement ends. In case of the test conductors designed as the wires the contact elements can be commercially available electrical connectors connected to the respective ends of the test conductors. In case of the test conductors designed as the electrode lines the contact elements can be contact pads connected to the respective ends of the electrode lines. Alternatively, the contact elements can be surface mounted connectors connected to the respective ends of the electrode line.

According to an advantageous aspect of the invention, the measurement ends or the measurement contact elements of the two test conductors are electrically connected via a connection element. Preferably, the connection element comprises a connection contact element at which the measurement potential can be measured.

To allow for integration of the fabrication process of the panel damage detection arrangement with known liquid crystal manufacturing technologies, according to an advantageous embodiment of the invention the two panels are manufactured from a silica-based glass.

According to an advantageous aspect of the invention, the panel damage detection arrangement comprises at least two measurement cells, wherein the two electrically connected measurement ends of the first measurement cell are electrically interconnected with the two electrically connected measurement ends of a second measurement cell so that when a first test voltage is applied to the source ends of the first measurement cell and a second test voltage is applied to the source ends of the second measurement cell a first measurement potential of the first measurement cell and a second measurement potential of the second measurement cell are summed up to a summed measurement potential. In such a way a mechanical damage to any of the panels of the at least two panel damage detection arrangements can be deduced from the change in the summed measurement potential.

The test voltages applied to the measurement cells can be of equal value. In case of the two test resistances of each measurement cell being equal for a non-damaged panel damage detection arrangement the summed measurement potential add up to the first test voltage if the first test voltage and the second test voltage are equal. In case one of the first test conductors of the first measurement cell or the second measurement cell is ruptured by a mechanical damage to the respective panel the measurement potential drops to half of the first test voltage. In case one of the second test conductors of the first measurement cell or the second measurement cell is ruptured by a mechanical damage to the respective panel the measurement potential increases to one and a half of the first test voltage. In such a way a damage to one of the panels of the panel damage detection arrangement can be deduced from the summed measurement potential. It is also possible to identify the damaged panel by additionally measuring the measurement potential of each measurement cell after a damage to one of the panels has been detected by the measurement of a change of the summed measurement potential.

To allow for better identification of a defective panel with a ruptured test conductor within one of the respective measurement cells on the basis of a single measurement of the summed measurement potential preferentially the test voltage applied to each of the measurement cells is preset to a suitable different value.

### Brief description of the drawings

The present invention will be more fully understood, and further features will become apparent, when reference is made to the following detailed description and the accompanying drawings. The drawings are merely representative and are not intended to limit the scope of the claims. In fact, those of ordinary skill in the art may appreciate upon reading the following specification and viewing the present drawings that various modifications and variations can be made thereto without deviating from the innovative concepts of the invention. Like parts depicted in the drawings are referred to by the same reference numerals.
Figure 1 illustrates a schematic view of an embodiment of a panel damage detection arrangement,
Figure 2 illustrates a schematic equivalent circuit of the embodiment of the panel damage detection arrangement illustrated in figure 1,
Figure 3 illustrates a schematic view of an alternative embodiment of the panel damage detection arrangement, and
Figure 4 illustrates schematic top view of an embodiment of the panel damage detection arrangement with three measurement cells.

### Detailed description of the drawings

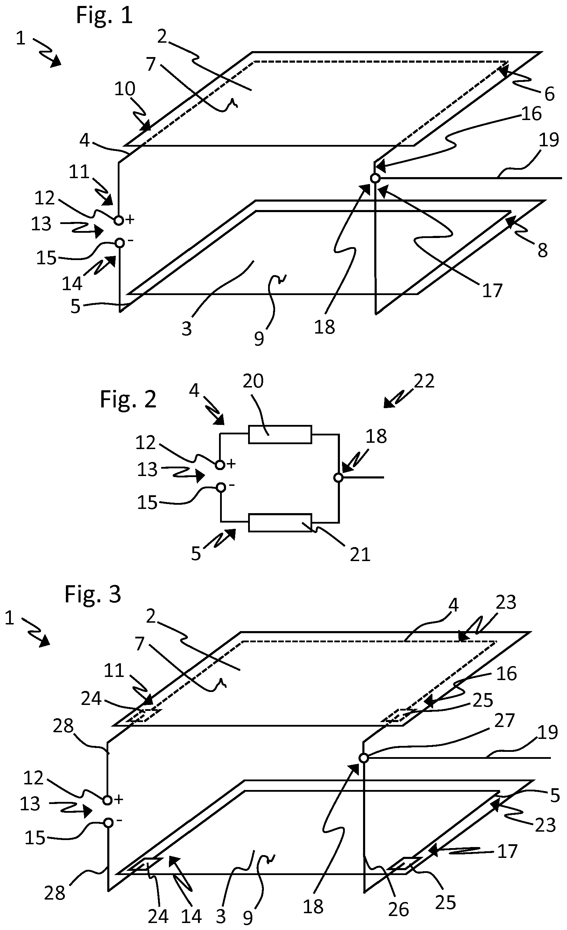

Figure 1 illustrates a schematic view of an embodiment of a panel damage detection arrangement 1 comprising a first panel 2 and a second panel 3, both fabricated from a non-conducting material. Furthermore, the panel damage detection arrangement 1 comprises a first test conductor 4 and a second test conductor 5. In the embodiment of the panel damage detection arrangement 1 shown in figure 1 the two test conductors 4, 5 are thin metallic wires. An attached section 6 of the first test conductor 4 is bonded to a test surface 7 of the first panel 2 while an attached section 8 of the second test conductor 4 is bonded to a test surface 9 of the second panel 3. Each of the attached sections 6, 8 runs a u-formed course along edge sections 10 of the respective panel 2, 3.

A source end 11 of the first conductor 4 is electrically connected to a high test potential 12 of a test voltage 13 provided by a constant voltage source. A source end 14 of the second test conductor 5 is connected to a low test potential 15 of the test voltage 13. A measurement end 16 of the first test conductor 4 and a measurement end 17 of the second test conductor 5 are electrically connected, so that a common measurement potential 18 is created at the connected measurement ends 16, 17. The measurement potential can be measured by a measurement line 19.

Figure 2 illustrates an equivalent circuit of the embodiment of the panel damage detection arrangement 1 shown in figure 1. The first test conductor 4 exhibits a first test resistance 20 and the second test conductor 5 exhibits a second test resistance 21. In case one of the two panels 2, 3 is mechanically damaged the test resistance 20, 21 of the respective test conductor 4, 5 is increased. The first test resistance 20 and the second test resistance 21 of the undamaged panels 2, 3 of the embodiment shown in figure 1 exhibit both an equal resistance. The equivalent circuit shows that the test panel arrangement 1 acts similar to a voltage divider. If the first panel 2 is mechanically damaged and thus the first test resistance 20 is increased, the measurement potential 18 is decreased. If the second panel 3 is mechanically damaged and the second test resistance 21 is thus increased, the measurement potential 18 is increased. In such way a technological implementation of mechanical damage monitoring of the two panels 2, 3 can be simplified.

The two panels 2, 3 together with the two test conductors 4, 5 with electrically connected measurement ends 11, 14 form a measurement cell 22.

Figure 3 illustrates a schematic view of an alternative embodiment of the panel damage detection arrangement 1. Here the first test conductors 4, 5 are manufactured as electrode lines 23 deposited on the respective test surface 7, 9 of the respective panel 2, 3. The source ends 11, 14 of the two test conductors 4, 5 are electrically connected to source contact elements 24 and the measurement ends 16, 17 are electrically connected to measurement contact elements 25. The measurement contact elements 25 of the two test conductors 4, 5 are electrically connected via a connection element 26. The connection element 26 comprises a connection contact element 27 to which the measurement line 19 is connected. The source contact elements 24 are connected to the respective potential 12, 15 of test voltage 13 via test lines 28.

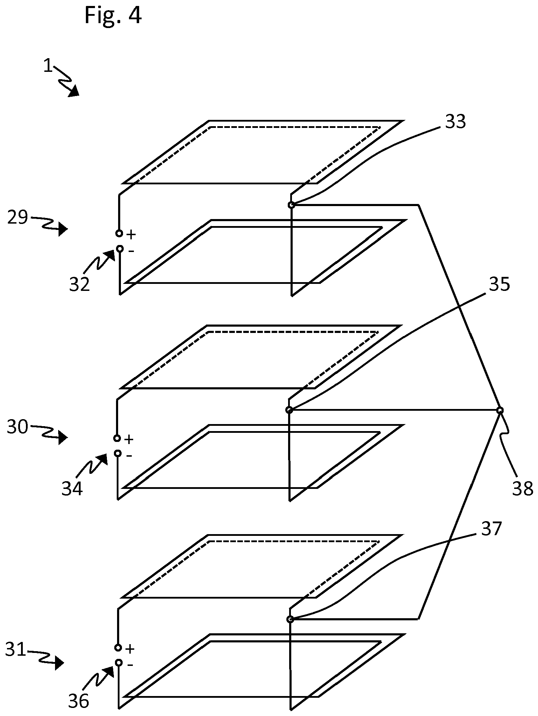

Figure 4 illustrates yet another embodiment of the panel damage detection arrangement 1 with a first measurement cell 29, a second measurement cell 30 and a third measurement cell 31. A first test voltage 32 is applied to the source ends 11, 14 of the first measurement cell 29 creating a first measurement potential 33 at the measurement ends 16, 17 of the first measurement cell 29. A second test voltage 34 is applied to the source ends 11, 14 of the second measurement cell 30 creating a second measurement potential 35 at the measurement ends 16, 17 of the second measurement cell 30. A third test voltage 36 is applied to the source ends 11, 14 of the third measurement cell 31 creating a third measurement potential 37 at the measurement ends 16, 17 of the third measurement cell 31. The measurement potentials 33, 35, 37 add up to the summed measurement potential 38. From the summed measurement potential 38 a damage to one of the panels (2, 3) of the measurement cells (29, 30, 31) can be deduced.

## Claims

1. Panel damage detection arrangement (1) comprising at least two non-conducting panels (2, 3), wherein a first test conductor (4) having a first test resistance (20) is at least sectionwise attached to a test surface (7) of a first panel (2) so that a mechanical damage to the first panel (2) is determinable from an increase in the first test resistance (20), wherein a second test conductor (5) having a second test resistance (21) is at least sectionwise attached to a test surface (9) of a second panel (3) so that a mechanical damage to the second panel (3) is determinable from an increase in the second test resistance (21), wherein the two test conductors (4, 5) each extend from a source end (11, 14) to a measurement end (16, 17), wherein the measurement ends (16, 17) of the two test conductors (4, 5) are electrically connected and wherein the first panel (2) and the second panel (3) with the respective test conductors (4, 5) form a measurement cell (22, 29, 30, 31), so that when a test voltage (13, 32, 34, 36) with a high test potential (11) is applied to the source end (11) of the first test conductor (4) and with a low test potential (15) to the source end (14) of the second test conductor (5) a common measurement potential (18, 33, 35, 37) created at the two measurement ends (16, 17) of the two test conductors (4, 5) shifts to a higher value if the second panel (3) is mechanically damaged and shifts to a lower value if the first panel (2) is mechanically damaged.

2. Panel damage detection arrangement (1) according to claim 1, **characterized in that** the section of the first test conductor (4) and/or the second test conductor (5) attached to the respective panel (2, 3) runs at least sectionwise from a first end section of the respective panel (2, 3) to a second end section of the respective panel (2, 3) arranged opposite to the first end section.

3. Panel damage detection arrangement (1) according to one or more of the claims 1 to 2, **characterized in that** the section of the first test conductor (4) and/or the second test conductor (5) attached to the respective panel (2, 3) runs at least sectionwise along an edge section (10) of the respective panel (2, 3).

4. Panel damage detection arrangement (1) according to one or more of the preceding claims, **characterized in that** the section of the first test conductor (4) and/or the second test conductor (5) attached to the respective panel (2, 3) runs at least sectionwise along a meandering course along the respective panel (2, 3).

5. Panel damage detection arrangement (1) according to one or more of the preceding claims, **characterized in that** the first test conductor (4) and/or the second test conductor (5) is at least sectionwise formed as an electrode line (23) on the test surface (7, 9) of the respective panel (2, 3).

6. Panel damage detection arrangement (1) according to one or more of the preceding claims, **characterized in that** the panel damage detection arrangement (1) comprises source contact elements (24) each electrically connected to one of the source ends (11, 14) of the test conductors (4, 5) and wherein the panel damage detection arrangement (1) comprises measurement contact elements (25) each electrically connected to one of the measurement ends (16, 17).

7. Panel damage detection arrangement (1) according to one or more of the preceding claims, **characterized in that** the measurement ends (16, 17) or the measurement contact elements (25) of the two test conductors (4, 5) are electrically connected via a connection element (26).

8. Panel damage detection arrangement (1) according to one or more of the preceding claims, **characterized in that** the two panels (2, 3) are manufactured from a silica-based glass.

9. Panel damage detection arrangement (1) according to one or more of the preceding claims, **characterized in that** the panel damage detection arrangement (1) comprises at least two measurement cells (22, 29, 30, 31), wherein the two electrically connected measurement ends (16, 17) of the first measurement cell (29) are electrically interconnected with the two electrically connected measurement ends (16, 17) of a second measurement cell (30) so that when a first test voltage (32) is applied to the source ends (11, 14) of the first measurement cell (29) and a second test voltage (34) is applied to the source ends (11, 14) of the second measurement cell (30) a first measurement potential (33) of the first measurement cell (29) and a second measurement potential (35) of the second measurement cell (30) are summed up to a summed measurement potential (38).
